# EUROPEAN PATENT APPLICATION

(11) **EP 4 807 346 A1**
(43) Date of publication of application: **16.09.2026**
(21) Application number: 26161139.6
(22) Date of filing: 26.02.2026
(51) Int. Cl.: G01N 21/3581, G01R 31/392, G06N 3/0464

(54) **BATTERY PACK AND BATTERY CONDITION PREDICTION APPARATUS AND METHOD**

(30) Priority: 13.03.2025 KR 20250032727
(71) Applicant: SAMSUNG SDI CO., LTD., Yongin-si, Gyeonggi-do 17084 (KR)
(72) Inventor: KIM, Min Su, 16678 Suwon-si (KR)
(74) Representative: Marks & Clerk LLP

(57) **Abstract**

A battery condition prediction apparatus includes a processor, and a memory that stores instructions executed by the processor, wherein the processor is configured to predict a condition or a lifetime of a battery based on features extracted from scan data generated based on terahertz waves transmitted through the battery.

## Description

### BACKGROUND

### 1. Field

Aspects of the present disclosure relate to a battery pack and a battery condition prediction apparatus and method of performing the prediction.

### 2. Description of the Related Art

xEVs such as electric vehicles (EVs) and hybrid electric vehicle (HEVs) are playing a key role in the eco-friendly automobile market. One of the most important factors that determine the performance and safety of such an xEV is a battery pack.

The battery pack applied to the electric vehicle and the like may include a plurality of battery packs that include a battery module and a slave battery management system (BMS) for managing the battery module. In addition, the battery system may further include a master BMS that communicates with a vehicle system and manages the plurality of battery packs.

Because such batteries may face performance degradation and safety problems as a usage time increases, it is very important to accurately monitor a state of a battery and accurately predict the lifetime of the battery based on the monitored state of the battery. Accordingly, various technologies for battery condition monitoring and lifetime prediction are known.

However, the existing methods each have their own limitations.

For example, there are problems in that a BMS-based method has difficulty in detecting minute changes inside a battery, impedance spectroscopy (EIS) has limitations in real-time monitoring, a data-based approach requires a large amount of training data, and ultrasonic technology has difficulty in directly observing chemical changes inside a battery.

The above information disclosed in this Background section is for enhancement of understanding of the background of the present disclosure, and therefore, it may contain information that does not constitute related (or prior) art.

### SUMMARY

Aspects of some embodiments of the present invention are directed to providing a battery pack and a battery condition prediction apparatus and a prediction method in which terahertz waves and Al technologies are combined to monitor changes inside a battery in real time, predict a lifetime of a battery without a large amount of data, detect imbalance between individual battery cells, implement non-destructive high-resolution analysis, and operate efficiently even in a low-power environment.

However, objects that the present invention intends to achieve are not limited to the above-described objects and other objects that are not described may be clearly understood by those skilled in the art from the following description.

According to some embodiments of the present invention, there is provided a battery condition prediction apparatus including: a processor; and a memory that stores instructions executed by the processor, wherein the processor is configured to predict a condition or a lifetime of a battery based on features extracted from scan data generated based on terahertz waves transmitted through the battery.

In some embodiments, the battery condition prediction apparatus further includes: a terahertz 3D scanning module configured to generate the terahertz waves, to receive the terahertz waves transmitted through the battery, and to convert the received terahertz waves into an electrical signal, wherein the processor is configured to acquire the scan data from the terahertz 3D scanning module, and wherein the terahertz 3D scanning module is configured to generate the terahertz waves by exciting a photoconductive antenna using a pulsed laser.

In some embodiments, the processor is configured to extract the features extracted from the scan data and to perform resolution upscaling through super-resolution processing to predict the condition or the lifetime of the battery.

In some embodiments, the processor is configured to calculate a jellyroll expansion coefficient based on the super-resolution processed data, and to predict the lifetime of the battery using at least one designated parameter including the jellyroll expansion coefficient using an ensemble model.

In some embodiments, the processor is configured to use at least one of a 3D convolutional neural network (3D CNN), a deep learning-based super-resolution technique, and an ensemble learning technique in a process of predicting the condition or the lifetime of the battery.

In some embodiments, the processor is configured to: acquire raw 3D voxel data from the terahertz 3D scanning module, perform noise removal and normalization of the raw 3D voxel data through data preprocessing, extract spatial features of the data using a 3D CNN, perform 3D super-resolution processing based on the spatial features to perform data upscaling, calculate a jellyroll expansion coefficient using the upscaled data, and predict the lifetime of the battery using an ensemble model.

In some embodiments, in order to extract the spatial features of the data, the processor is configured to: extract local features of input data through a first convolutional layer, learn a more complex combination of features extracted from the first convolutional layer through a second convolutional layer, and compress and refine the features through a third convolutional layer.

In some embodiments, in order to perform the data upscaling by performing the 3D super-resolution processing, the processor is configured to: expand a spatial dimension of input data through a first deconvolutional layer, refine detailed features of data whose spatial dimension is expanded through a refinement convolutional layer, and reduce an artifact that occurs during the data upscaling, and generate a final output through a final convolutional layer and normalize an output value through a sigmoid activation function.

In some embodiments, in order to calculate the jellyroll expansion coefficient, the processor is configured to: estimate an initial volume by summing all voxel values of initial scan data, estimate a current volume by summing all voxel values of current scan data, and calculate the expansion coefficient as a percentage by using (current volume-initial volume)/initial volume*100.

In some embodiments, in order to predict the lifetime of the battery using the ensemble model, the processor is configured to: generate the ensemble model including a plurality of decision trees trained to predict the lifetime of the battery using input variables including a voltage, a current, a temperature, and an expansion coefficient, and receive the voltage, the current, the temperature, and the expansion coefficient as inputs, and synthesize the prediction results of each decision tree by the generated ensemble model to predict the lifetime of the battery.

According to some embodiments of the present invention, there is provided a battery condition prediction method including: extracting, by a processor, features from scan data generated based on terahertz waves transmitted through a battery; and predicting, by the processor, a condition or a lifetime of the battery based on the extracted features.

In some embodiments, in the predicting of the condition or the lifetime of the battery, the processor is configured to extract the features from the scan data and to perform resolution upscaling through super-resolution processing.

In some embodiments, in the predicting of the condition or the lifetime of the battery, the processor is configured to calculate a jellyroll expansion coefficient based on the super-resolution processed data, and to predict the lifetime of the battery using at least one designated parameter including the jellyroll expansion coefficient using an ensemble model.

In some embodiments, in the predicting of the condition or the lifetime of the battery, the processor is configured to use at least one of a 3D convolutional neural network (3D CNN), a deep learning-based super-resolution technique, and an ensemble learning technique.

In some embodiments, in the predicting of the condition or the lifetime of the battery, the processor is configured to: acquire raw 3D voxel data from a terahertz 3D scanning module, perform noise removal and normalization of the raw 3D voxel data through data preprocessing, extract spatial features of the data using a 3D CNN, perform 3D super-resolution processing based on the spatial features to perform data upscaling, calculate a jellyroll expansion coefficient using the upscaled data, and predict the lifetime of the battery using an ensemble model.

In some embodiments, in order to extract the spatial features of the data, the processor is configured to: extract local features of input data through a first convolutional layer, learn a more complex combination of features extracted from the first convolutional layer through a second convolutional layer, and compress and refine the features through a third convolutional layer.

In some embodiments, in order to perform the data upscaling by performing the 3D super-resolution processing, the processor is configured to: extract local features of input data through a first deconvolutional layer, refine detailed features of the data whose spatial dimension is expanded through a refinement convolutional layer and reduce an artifact that occurs during the data upscaling, and generate a final output through a final convolutional layer and normalizes an output value through a sigmoid activation function.

In some embodiments, in order to calculate the jellyroll expansion coefficient, the processor is configured to: estimate an initial volume by summing all voxel values of an initial scan data, estimate a current volume by summing all voxel values of current scan data, and calculate the expansion coefficient as a percentage by using (current volume-initial volume)/initial volume*100.

In some embodiments, in order to predict the lifetime of the battery using the ensemble model, the processor is configured to: generate the ensemble model including a plurality of decision trees trained to predict the lifetime of the battery using input variables including a voltage, a current, a temperature, and an expansion coefficient, and receive the voltage, the current, the temperature, and the expansion coefficient as inputs, and synthesize the prediction results of each decision tree by the generated ensemble model to predict the lifetime of the battery.

According to some embodiments of the present invention, there is provided a battery pack including: a processor; and a memory that stores instructions executed by the processor, wherein the processor is configured to predict a condition or a lifetime of a battery based on features extracted from scan data generated based on terahertz waves transmitted through the battery.

At least some of the above and other features of the invention are set out in the claims.

### BRIEF DESCRIPTION OF THE DRAWINGS

The following drawings attached to this specification illustrate some embodiments of the present disclosure, and further describe aspects and features of the present disclosure together with the detailed description of the present disclosure. Thus, the present disclosure should not be construed as being limited to the drawings:
FIG. 1 is an example diagram illustrating a schematic configuration of a battery condition prediction apparatus according to some embodiments of the present invention;
FIG. 2 is a flowchart illustrating a data processing and analysis method of a processor in FIG. 1, according to some embodiments of the present invention;
FIG. 3 is an example diagram illustrating the form of voxel data of 3*3*3 size acquired from a terahertz 3D scanner in the process of FIG. 2, according to some embodiments of the present invention;
FIG. 4 is an example diagram illustrating the form of data after the preprocessing of FIG. 3, according to some embodiments of the present invention;
FIG. 5 is a flowchart illustrating a feature extraction operation of FIG. 2 using a 3D convolutional neural network (3D CNN), according to some embodiments of the present invention;
FIG. 6 is a flowchart illustrating a data upscaling operation of FIG. 2 using super-resolution processing, according to some embodiments of the present invention; and
FIG. 7 is a flowchart illustrating a jellyroll expansion coefficient calculation operation of FIG. 2, according to some embodiments of the present invention.

### DETAILED DESCRIPTION

Hereinafter, embodiments of the present disclosure will be described, in detail, with reference to the accompanying drawings. The terms or words used in this specification and claims should not be construed as being limited to the usual or dictionary meaning and should be interpreted as meaning and concept consistent with the technical idea of the present disclosure based on the principle that the inventor can be his/her own lexicographer to appropriately define the concept of the term to explain his/her invention in the best way.

The embodiments described in this specification and the configurations shown in the drawings are only some of the embodiments of the present disclosure and do not represent all of the technical ideas, aspects, and features of the present disclosure. Accordingly, it should be understood that there may be various equivalents and modifications that can replace or modify the embodiments described herein at the time of filing this application.

It will be understood that when an element or layer is referred to as being "on," "connected to," or "coupled to" another element or layer, it may be directly on, connected, or coupled to the other element or layer or one or more intervening elements or layers may also be present. When an element or layer is referred to as being "directly on," "directly connected to," or "directly coupled to" another element or layer, there are no intervening elements or layers present. For example, when a first element is described as being "coupled" or "connected" to a second element, the first element may be directly coupled or connected to the second element or the first element may be indirectly coupled or connected to the second element via one or more intervening elements.

In the figures, dimensions of the various elements, layers, etc. may be exaggerated for clarity of illustration. The same reference numerals designate the same elements. As used herein, the term "and/or" includes any and all combinations of one or more of the associated listed items. Further, the use of "may" when describing embodiments of the present disclosure relates to "one or more embodiments of the present disclosure." Expressions, such as "at least one of" and "any one of," when preceding a list of elements, modify the entire list of elements and do not modify the individual elements of the list. When phrases such as "at least one of A, B and C, "at least one of A, B or C," "at least one selected from a group of A, B and C," or "at least one selected from among A, B and C" are used to designate a list of elements A, B and C, the phrase may refer to any and all suitable combinations or a subset of A, B and C, such as A, B, C, A and B, A and C, B and C, or A and B and C. As used herein, the terms "use," "using," and "used" may be considered synonymous with the terms "utilize," "utilizing," and "utilized," respectively. As used herein, the terms "substantially," "about," and similar terms are used as terms of approximation and not as terms of degree, and are intended to account for the inherent variations in measured or calculated values that would be recognized by those of ordinary skill in the art.

It will be understood that, although the terms first, second, third, etc. may be used herein to describe various elements, components, regions, layers, and/or sections, these elements, components, regions, layers, and/or sections should not be limited by these terms. These terms are used to distinguish one element, component, region, layer, or section from another element, component, region, layer, or section. Thus, a first element, component, region, layer, or section discussed below could be termed a second element, component, region, layer, or section without departing from the teachings of example embodiments.

Spatially relative terms, such as "beneath," "below," "lower," "above," "upper," and the like, may be used herein for ease of description to describe one element or feature's relationship to another element(s) or feature(s) as illustrated in the figures. It will be understood that the spatially relative terms are intended to encompass different orientations of the device in use or operation in addition to the orientation depicted in the figures. For example, if the device in the figures is turned over, elements described as "below" or "beneath" other elements or features would then be oriented "above" or "over" the other elements or features. Thus, the term "below" may encompass both an orientation of above and below. The device may be otherwise oriented (rotated 90 degrees or at other orientations), and the spatially relative descriptors used herein should be interpreted accordingly.

The terminology used herein is for the purpose of describing embodiments of the present disclosure and is not intended to be limiting of the present disclosure. As used herein, the singular forms "a" and "an" are intended to include the plural forms as well, unless the context clearly indicates otherwise. It will be further understood that the terms "includes," "including," "comprises," and/or "comprising," when used in this specification, specify the presence of stated features, integers, steps, operations, elements, and/or components but do not preclude the presence or addition of one or more other features, integers, steps, operations, elements, components, and/or groups thereof.

Also, any numerical range disclosed and/or recited herein is intended to include all sub-ranges of the same numerical precision subsumed within the recited range. For example, a range of "1.0 to 10.0" is intended to include all subranges between (and including) the recited minimum value of 1.0 and the recited maximum value of 10.0, that is, having a minimum value equal to or greater than 1.0 and a maximum value equal to or less than 10.0, such as, for example, 2.4 to 7.6. Any maximum numerical limitation recited herein is intended to include all lower numerical limitations subsumed therein, and any minimum numerical limitation recited in this specification is intended to include all higher numerical limitations subsumed therein. Accordingly, Applicant reserves the right to amend this specification, including the claims, to expressly recite any sub-range subsumed within the ranges expressly recited herein.

References to two compared elements, features, etc., as being "the same" may mean that they are "substantially the same". Thus, the phrase "substantially the same" may include a case having a deviation that is considered low in the art, for example, a deviation of 5% or less. In addition, when a certain parameter is referred to as being uniform in a given region, it may mean that it is uniform in terms of an average.

Throughout the specification, unless otherwise stated, each element may be singular or plural.

When an arbitrary element is referred to as being disposed (or located or positioned) on the "above (or below)" or "on (or under)" a component, it may mean that the arbitrary element is placed in contact with the upper (or lower) surface of the component and may also mean that another component may be interposed between the component and any arbitrary element disposed (or located or positioned) on (or under) the component.

In addition, it will be understood that when an element is referred to as being "coupled," "linked" or "connected" to another element, the elements may be directly "coupled," "linked" or "connected" to each other, or an intervening element may be present therebetween, through which the element may be "coupled," "linked" or "connected" to another element. In addition, when a part is referred to as being "electrically coupled" to another part, the part can be directly connected to another part or an intervening part may be present therebetween such that the part and another part are indirectly connected to each other.

Throughout the specification, when "A and/or B" is stated, it means A, B or A and B, unless otherwise stated. That is, "and/or" includes any or all combinations of a plurality of items enumerated. When "C to D" is stated, it means C or more and D or less, unless otherwise specified.

A battery pack includes at least one battery module and a pack housing having an accommodation space for accommodating the at least one battery module.

The battery module may include a plurality of battery cells and a module housing. The battery cells may be accommodated inside the module housing in a stacked form. The battery cell may include a positive lead and a negative lead. Depending on the shape of the battery, round, square, or pouch type battery cells may be used.

In the battery pack, one stacked cell stack instead of the battery module may form one module. The cell stack may be accommodated in an accommodating space of a pack housing or may be accommodated in an accommodating space partitioned by a frame, a partition, etc.

The battery cells generate a large amount of heat during charging/discharging. The generated heat is accumulated in the battery cells and accelerates the degradation of the battery cells. Therefore, the battery pack further includes a cooling member to suppress degradation of the battery cells. The cooling member is provided under the accommodating space where the battery cells are accommodated, but is not limited thereto, and may also be provided at an upper portion or a side surface depending on the battery pack.

Exhaust gas inside each of the battery cells and generated in abnormal operating conditions, known as thermal runaway or thermal event of the battery cell, may be discharged outside the battery cells. The battery pack or the battery module may be provided with an exhaust port or the like for discharging the exhaust gas to prevent or substantially reduce damage to the battery pack or module.

The battery pack may include a battery and a battery management system (BMS) for managing the battery. The BMS may include a detection device, a balancing device, and a control device. The battery module may include a plurality of cells connected in series, in parallel, or a combination of the two. The battery modules may be connected in series, in parallel, or a combination of the two.

The detection device may detect state information indicating a state of a battery by detecting the state (e.g., voltage, current, temperature, etc.) of the battery. The detection device may detect a voltage of each cell constituting the battery or each battery module. The detection device may also detect a current flowing through the battery module or each battery module constituting the battery pack. The detection device may also detect cell and/or module and/or ambient temperature at at least one point of the battery.

The balancing device may perform a balancing operation of the battery modules and/or cells constituting the battery. The control device may receive the state information (e.g., voltage, current, temperature, etc.) of the battery module from the detection device. The control device may monitor and calculate the state (e.g., voltage, current, temperature, state of charge (SoC), state of health (SoH), etc.) of the battery module based on the state information received from the detection device. In addition, based on the state monitoring results, the control device may perform a control function (e.g., temperature control, balancing control, charging/discharging control, etc.), a protection function (e.g., overdischarge, overcharge, overcurrent prevention, short circuit, fire extinguishing function, etc.), etc. In addition, the control device may perform wired or wireless communication functions with external devices (e.g., upper controller, vehicle, charger, or PCS, etc.) of the battery pack.

The control device may also control the charging/discharging operation and protection operation of the battery. To this end, the control device may include a charging/discharging control unit, a balancing control unit, and a protection unit.

The BMS is a system that monitors the state of the battery, and performs diagnosis and control, communication, and protection functions, and may calculate a charging/discharging state, calculate a lifetime or SoH of a battery, cut off battery power (e.g., through relay control) when desired, control thermal management (e.g., cooling, heating, etc.), perform high-voltage interlock functions, and detect or calculate insulation and short-circuit conditions.

A relay may be a mechanical contactor that is turned on and off by the magnetic force of a coil, or a semiconductor switch such as a metal oxide semiconductor field effect transistor (MOSFET).

The relay control may be formed of one or more relays and precharge relays on the positive and negative terminals of the battery to cut off the supply of power from the battery when a problem occurs in the vehicle and battery system.

Because there is a risk of inrush current occurring in a high-voltage capacitor on an inverter input side when a battery load is connected, to prevent or substantially reduce the inrush current, the relay may include a function of operating a precharge relay to connect to a precharge resistor before connecting a main relay during vehicle startup.

A high-voltage interlock is a circuit that uses a small signal to detect whether all high-voltage components in the entire automobile system are connected and may be equipped with a function that forcibly opens the relay when an open condition occurs anywhere in the entire loop.

Hereinafter, the terahertz wave described in some embodiments is an electromagnetic wave with a frequency of about 0.110 THz, and and as a consequence of said frequency has penetrability (i.e., characteristics useful for analyzing internal structures by transmitting many non-metallic materials), safety (i.e., characteristics safe for living organisms due to non-ionizing radiation, unlike X-rays), high resolution (i.e., characteristics providing high spatial resolution at a submillimeter level due to a short wavelength), and spectral characteristics (i.e., characteristics useful for material identification by providing unique spectral characteristic ratios of various materials).

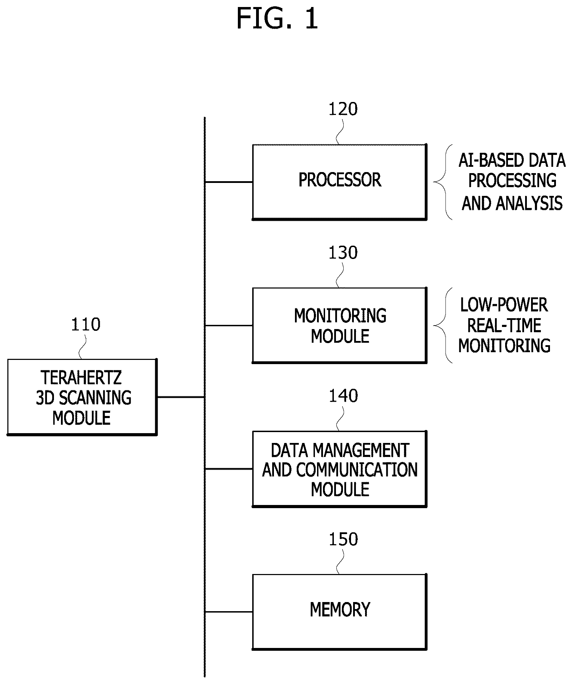

FIG. 1 is an example diagram illustrating a schematic configuration of a battery condition prediction apparatus according to some embodiments of the present invention.

Referring to FIG. 1, a battery condition prediction apparatus according to some embodiments may include a terahertz 3D scanning module 110, a processor 120, a monitoring module 130, a data management and communication module 140, and a memory 150. Among the components configuring the battery condition prediction apparatus, the processor 120, the monitoring module 130, the data management and communication module 140, and the memory 150 may be integrated and implemented in the above-described BMS. For example, the processor 120 and the data management and communication module 140 may be integrated and implemented in a micro controller unit (MCU) of the BMS, and the monitoring module 130 may be implemented in an analog front end integrated circuit (AFE IC) of the BMS.

The terahertz 3D scanning module 110 (i.e., a terahertz 3D scanner) may generate terahertz waves (e.g., 0.1 THz to 0.5 THz) by exciting a photoconductive antenna with a pulsed laser (i.e., supplying specific energy to the photoconductive antenna with a pulsed laser). After the terahertz waves transmit through the battery, the terahertz waves may be received by a detector and converted into an electrical signal.

Here, the detector is a device for converting the received terahertz wave into the electrical signal, and the photoconductive antenna may not only generate terahertz waves, but also convert the received terahertz waves into the electrical signal, and may include a bolometer, a pyroelectric detector, a high-temperature superconducting detector, a diode detector, and/or the like, in addition to the photoconductive antenna.

The terahertz 3D scanning module 110 enables 3D scanning of the battery through a beam steering system (i.e., a system that controls a direction of a beam such as an electromagnetic wave or laser), and a signal may be amplified and digitized through a low-noise amplifier (LNA) and an analog-to-digital converter (ADC).

For example, the terahertz 3D scanning module 110 may generate a 3D image with a 3 mm voxel resolution at a refresh rate of 10 Hz through the terahertz 3D scanner mounted on a battery pack used in an electric vehicle (xEV), and assuming an example scan area of 100*100*30 voxel size, 3 million data points may be generated per second.

Here, a voxel (volume element) is a unit of data expression in a 3D space. When a pixel is a minimum unit that constitutes a 2D image, a voxel is a minimum unit that constitutes 3D data. The voxel has a size and value at a specific coordinate and is mainly used in visualization and analysis of the 3D data. The smaller the voxel size, the higher the resolution 3D data may be expressed, and a small voxel expresses 3D data in more detail, but consumes much memory and many computational resources.

Accordingly, the terahertz 3D scanning module 110 may include at least a femtosecond pulsed laser diode (wavelength 780 nm, output power < 10 mW), a nano-structured photoconductive antenna (substrate: semi-insulating GaAs, electrode spacing: 5 µm), a phased array-based electronic beam steering system, an LNA, and an ADC. However, embodiments of the present disclosure are not limited thereto.

The processor 120 may perform data processing and analysis based on artificial intelligence (AI).

The processor 120 may extract features from scan data detected by the terahertz 3D scanning module 110 (i.e., the terahertz 3D scanner) through a 3D convolutional neural network (3D CNN), and upscale the extracted features to a resolution of 1 mm voxel (i.e., a volume element whose minimum unit in 3D data is 1 mm³ in size) through super-resolution processing.

Here, the super-resolution processing is a technology that converts a low-resolution image into a high-resolution image and improves image quality and restores small details to enable further analysis.

In addition, the processor 120 calculates a jellyroll expansion coefficient based on this super-resolution data, and an ensemble (e.g., random forest) model may predict a lifetime of a battery using various parameters (i.e., physical, chemical, environmental, or data-based parameters, etc.) including the jellyroll expansion coefficient. Herein, a jellyroll expansion coefficient may be a coefficient of thermal expansion of a jellyroll-type battery.

Here, the random forest is an ensemble learning technique (or model) widely used in data analysis and prediction and may create a more powerful and stable prediction model by combining multiple decision trees, and this ensemble (e.g., the random forest) model may be used for both classification and regression problems.

For example, the 3D CNN of the processor 120 may be composed of five convolutional layers, which may respectively use 32, 64, 128, 64, and 32 filters. The super-resolution processing may be performed through two deconvolutional layers and may ultimately generate an image with a resolution of 1 mm3 voxel. The random forest model may be composed of 100 decision trees, and may use multiple (e.g., 10) features, such as voltage, current, temperature, and expansion coefficient, as inputs.

Accordingly, the processor 120 may be implemented including at least a 3D CNN model, a deconvolutional neural network for super-resolution processing, a random forest regression model, an FPGA-based real-time signal processing system, and a low-power Al processor of a 28 nm fully depleted silicon-on-insulator (FD-SOI) process. However, embodiments of the present disclosure are not limited thereto.

The monitoring module 130 may dynamically adjust the voltage and frequency of the processor 120 according to a workload through a dynamic voltage and frequency scaling (DVFS) system.

The monitoring module 130 allows a power management integrated circuit (PMIC) to supply optimized power to each component of the battery condition prediction apparatus according to some embodiments and may reduce (e.g., minimize) unnecessary operations through firmware optimization.

For example, the processor 120 may operate at 500 MHz and 0.8 V when processing and analyzing data for general vehicle driving, and the power consumption may be 0.5 W or less. In addition, when high-intensity data processing and analysis are desired, the operating frequency and voltage of the processor 120 may temporarily increase to 1 GHz and 1.0 V and consume a maximum power of 2 W. The monitoring module 130 may monitor the operation of the processor 120.

Accordingly, the monitoring module 130 may be implemented including a DVFS system, a PMIC, and an optimized firmware and operating system. However, embodiments of the present disclosure are not limited thereto.

The data management and communication module 140 may periodically store scan data and analysis results in an internal memory (e.g., flash memory), and a security microcontroller may manage data encryption and access control, and may communicate with other systems of the vehicle through a protocol such as Controller Area Network with Flexible Data Rate (CAN-FD) (i.e., a protocol that provides high data transmission speed and efficiency and supports real-time communication with multiple electronic control units (ECUs) in the vehicle) or FlexRay (i.e., a communication support protocol that provides high bandwidth and reliability in systems where the safety and performance of the vehicle are important).

For example, the data management and communication module 140 may store compressed scan data and analysis results of a specified capacity (e.g., 1 MB) in the internal memory every specified time (e.g., 10 minutes). In addition, the data management and communication module 140 may share battery state information in real time with the vehicle ECU through the CAN-FD at a specified speed (e.g., 500 kbps).

Accordingly, the data management and communication module 140 may be implemented by including a built-in memory (e.g., 64 GB), a security microcontroller, and CAN-FD and FlexRay communication interfaces. However, embodiments of the present disclosure are not limited thereto.

Furthermore, the BMS learns battery usage patterns and environmental conditions through a pattern recognition algorithm, and based on the battery usage patterns and environmental conditions, a decision-making system may optimize charging/discharging power, temperature management, etc. (e.g., activating a cooling system when the battery is overheated, reducing the charging speed when necessary to prevent degradation of the battery, etc.).

The memory 150 may store instructions executed by the processor 120. In addition, the memory 150 may store at least one algorithm necessary for processing the instructions of the processor 120 and data necessary for executing the corresponding algorithm.

A real-time operating system (RTOS) may compensate the real-time property of the process.

For example, the BMS may learn a user's vehicle driving pattern and switch to a mode that optimizes a battery lifetime when a long-distance driving is expected. For example, the BMS may extend the lifetime of the battery by limiting a charge upper limit to 90% and adjusting a discharge lower limit to 15%.

Accordingly, the BMS may be implemented to include a machine learning-based pattern recognition algorithm, a rule-based decision-making system, and an RTOS. However, embodiments of the present disclosure are not limited thereto.

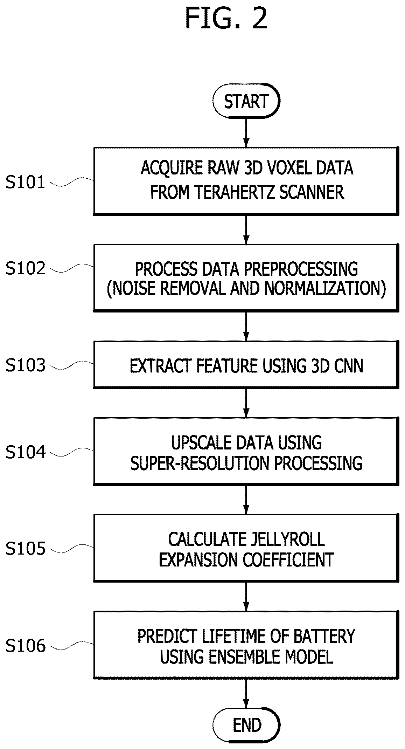

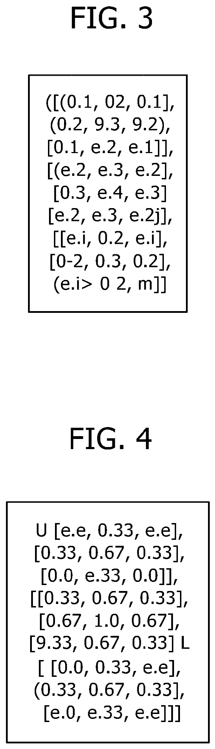

FIG. 2 is a flowchart illustrating a data processing and analysis method of a processor in FIG. 1, according to some embodiments of the present invention. FIG. 3 is an example diagram illustrating the form of 3*3*3 sized voxel data acquired from a terahertz 3D scanner in the process of FIG. 2, according to some embodiments of the present invention. FIG. 4 is an example diagram illustrating the form of data after the preprocessing of FIG. 3, according to some embodiments of the present invention.

In FIG. 2, the processor 120 may apply a 3D convolutional neural net (CNN), a deep learning-based super resolution technique, and an ensemble learning method (i.e., a machine learning technique that combines multiple models (e.g., a random forest regression) to achieve better performance than a single model) during the data processing and analysis.

The 3D CNN is an extension of a 2D CNN and may directly process 3D data, which can be suitable for effectively analyzing and upscaling voxel-based 3D scan data (i.e., converting low-resolution data into high-resolution).

The deep learning-based super resolution technique may convert low-resolution images into high-resolution images, and when applied to the 3D data, may effectively improve scan resolution.

In addition, the random forest regression, which is one of the ensemble learning methods, may perform regression analysis by configuring multiple decision trees, and may be suitable for the lifetime prediction of a battery with nonlinear characteristics.

Referring to FIG. 2, the processor 120 may acquire raw 3D voxel data from the terahertz 3D scanning module (i.e., the terahertz 3D scanner) 110 (S101).

Here, the raw 3D voxel data is data that is expressed in a state in which information on a 3D space has been minimally processed (or is unprocessed), and is data in a form directly generated from data sampling or sensing technology. The raw 3D voxel data is basically composed of voxels (i.e., the minimum unit of the 3D space), and each voxel may include specific properties (e.g., density, color, temperature, etc.).

The processor 120 may acquire the raw 3D voxel data from the terahertz 3D scanning module (i.e., the terahertz 3D scanner) 110. The raw 3D voxel data is in the form of a three-dimensional array, where each element of the array represents terahertz wave response intensity at a specific location, and may be, for example, formed as that illustrated in FIG. 3.

FIG. 3 illustrates the form of the raw 3D voxel data acquired through the terahertz 3D scanner. In this case, data is represented as a voxel array of 3×3×3 size, and each voxel represents the terahertz wave response intensity at the corresponding location. The voxel value may be normalized to a value between 0 and 1, and higher values may represent higher density of the material or may indicate that there is a structural change at that location.

In this raw 3D voxel data, each number may represent the terahertz wave response intensity at the corresponding location as a value between 0 and 1. In this case, higher values may represent higher density of the material or may indicate that there is a structural change at that location.

The processor 120 may perform a noise removal and normalization process of the raw data through the data preprocessing (S102).

In some examples, the noise may be removed using a Gaussian filter.

The noise removal process may smooth each voxel value by calculating a weighted average of surrounding voxel values. Here, smoothing the voxel value means reducing sudden spikes or outliers of data so that the values change gradually. For example, when a Gaussian filter with a sigma value set to 0.5 is applied, extreme values may be smoothed out, resulting in a smoother data distribution.

The normalization process may convert all values into a value between 0 and 1 using a Min-Max normalization method.

The normalization process may use a specified function (e.g., normalized_value = (value - min_value) / (max_value - min_value)).

Through this normalization process, a scale of data may be made constant, resulting in improved computational efficiency and accuracy in the subsequent processing. In this case, the data after the preprocessing may be formed in the form of FIG. 4.

FIG. 4 illustrates the results after preprocessing the raw 3D voxel data acquired in FIG. 3, where the preprocessing may include noise removal, normalization, and outlier removal. Accordingly, FIG. 4 has a smoother and more normalized data form than the raw 3D voxel data of FIG. 3 and is processed (e.g., optimized) for subsequent Al analysis.

The processor 120 may extract the spatial features of data using the 3D CNN (S103).

For example, in the first convolutional layer, local features of input data may be extracted using 32 3×3×3 filters, and non-linearity may be introduced using ReLU as an activation function; in the second convolutional layer, more complex combinations of features extracted from a first convolutional layer may be trained using 64 3×3×3 filters; and in the third convolutional layer, features may be compressed and refined again using 32 3×3×3 filters.

Here, the convolutional layer is a core component of the convolutional neural network (CNN) and serves to extract features from input data (e.g., images, 3D data, etc.), and the convolutional layer is very effective in training the spatial structure of data and plays a role (e.g., an important role) in pattern recognition and data analysis.

For reference, in the 2D CNN, images (e.g., 2D pixel data) are used as input data of the convolutional layer, and in the 3D CNN, the voxel data or the 3D images are used as input data of the convolutional layer. The filter of the convolutional layer is a core element that performs the convolution operation and is a small matrix or 3D tensor with weights. The convolutional layer applies the filter to the input data to calculate the values (of the feature map) at each location, and the operation result is generated through a dot product of the input data and the filter. An activation function of the convolutional layer may add non-linearity to the features extracted from the convolutional layer to train more complex patterns. It mainly converts negative numbers into 0 using a rectified linear unit (ReLU). A feature map of the convolutional layer is the output data obtained as a result of the convolution operation and expresses specific patterns or structural features detected by the filter in the input data.

After the feature extraction process is performed using the 3D CNN, the original data (3×3×3) may be converted into 32 feature maps (each with a size of, e.g., 3×3×3). These feature maps may represent various spatial characteristics (e.g., edge, texture, density change, etc.) of the original data.

The processor 120 may perform the 3D super-resolution processing based on the extracted features to perform the data upscaling (S104).

For example, the first deconvolutional layer uses 64 3×3×3 filters and is set to stride 2 so that the spatial dimension of the input data can be expanded by two times. In this process, new voxels may be generated, and their values may be estimated (calculated) based on the information of the surrounding voxels. The refinement convolutional layer may use 32 3×3×3 filters to refine the detailed features of the expanded data, reduce artifacts that may occur during the upscaling process, and generate more natural high-resolution data. The final convolutional layer may use a single 3×3×3 filter to generate the final output, and normalize the output value between 0 and 1 using the sigmoid activation function.

For reference, the first deconvolutional layer expands data to a larger size, reads the data using the 3D filter (e.g., a block of 3×3×3 filter), and fills an empty space (i.e., new voxels) based on the data, thereby creating data that is twice as large as the original data. The refinement convolutional layer further refines the "slightly awkward or unnatural parts" of the expanded data from the first convolutional layer, and may use another filter (e.g., a block of 3×3×3 filter) to enhance the detailed features (e.g., sharpness, texture) of the expanded data or reduce abnormal points (e.g., artifacts) occurring during the upscaling process. The final convolutional layer finally organizes data and completes the data into high-resolution data, normalizing the data (e.g., limiting the values to be between 0 and 1) to make it easier for the system to read. In other words, a single 3×3×3 filter and a sigmoid activation function may be used to make the upscaled data into a complete version.

Through this super-resolution processing, the original 3×3×3 data may be converted into high-resolution data of 6×6×6 size. The expanded data may express more detailed structural features than the original.

The processor 120 may calculate the jellyroll expansion coefficient using the upscaled data (S105).

For example, the initial volume may be estimated by summing all voxel values of the initial scan data. The current volume may be estimated by summing all voxel values of the current scan data. The expansion coefficient may be calculated as a percentage using the equation (current volume-initial volume)/initial volume*100. For example, when the initial volume is 100 and the current volume is 105, the expansion coefficient may be (105-100)/100*100=5%.

The processor 120 may predict the lifetime of the battery using the ensemble model (e.g., using a random forest model) (S106).

For example, the ensemble model may be created by configuring multiple decision trees to predict the lifetime of the battery. Each decision tree may be trained to predict the lifetime of the battery using input variables such as voltage, current, temperature, and expansion coefficient. For example, the decision tree may create rules through data, such as learning that the battery may deteriorate quickly when the temperature is too high. New battery data (e.g., a current voltage, a current, temperature, a calculated expansion coefficient) is received as an input, and the prediction results of each decision tree may be synthesized to predict the final lifetime.

For example, when the input data is [3.65 V, 2.2 A, 28 °C, 5.23%] (representative of a voltage, a current, a temperature, and an expansion coefficient), each decision tree can predict the remaining lifetime cycle of the battery based on the input data. For example, the result value may be expressed as a specific number such as "925" cycles (i.e., the battery may repeat charging and discharging approximately 925 times in the future).

Through this processing, the processor 120 may more accurately estimate (e.g., calculate) and output the current state and expected lifetime of the battery from the terahertz scan data.

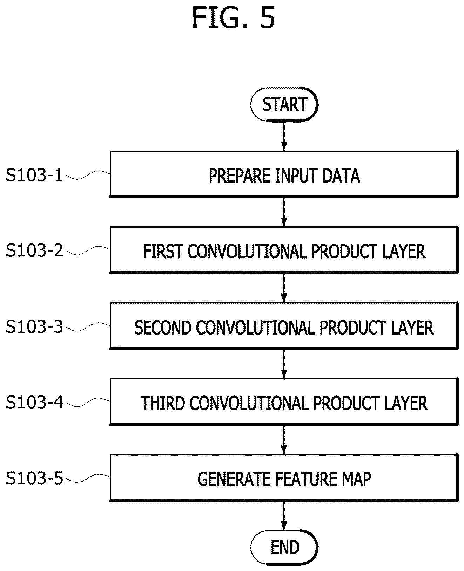

FIG. 5 is a flowchart illustrating a feature extraction operation of FIG. 2 using the 3D CNN in FIG. 2, according to some embodiments of the present invention.

Referring to FIG. 5, a feature extraction operation (S103) using the 3D CNN may include an operation (S103-1) of receiving preprocessed 3D voxel data (e.g., size: 32*32*32, channel: 1), an operation (S103-2) of performing ReLU activation by applying 32 3*3*3 filters in the first convolutional layer, an operation (S103-3) of performing ReLU activation by applying 64 3*3*3 filters in the second convolutional layer, an operation (S103-4) of performing ReLU activation by applying 32 3*3*3 filters in the third convolutional layer, and an operation (S103-5) of finally outputting 32 32*32*32 feature maps.

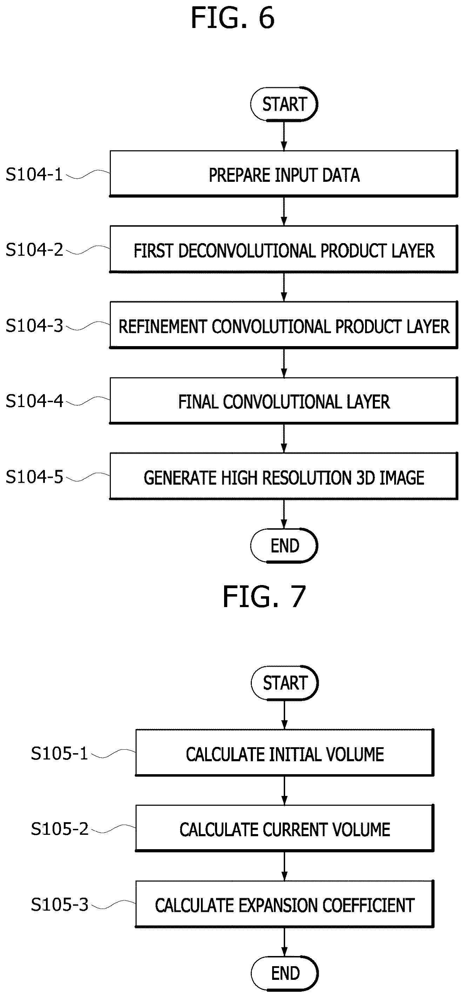

FIG. 6 is a flowchart for illustrating a data upscaling operation (S104) of FIG. 2 using super-resolution processing, according to some embodiments of the present invention.

Referring to FIG. 6, an operation (S104) of performing data upscaling using the super-resolution processing may include an operation (S104-1) of receiving the output feature map (e.g., of 32*32*32*32 size) of the 3D CNN, an operation (S104-2) in which, in the first deconvolutional layer, 64 3×3×3 filters are used, and a stride (in the deep learning, when a filter (kernel) moves over input data in the CNN or the deconvolutional neural network, an interval at which it moves at a time is referred to as a "stride") is set to 2 to double a spatial dimension of the input data, new voxels are created in this process, and their values are estimated (e.g., calculated) based on information from surrounding voxels, an operation (S104-3) of refining the detailed features of the expanded data using 32 3×3×3 filters in the refinement convolutional layer, reducing artifacts (i.e., the values of the newly generated voxels during the upscaling process that are not in harmony with the surrounding information, making the data look unnatural), an operation (S104-4) of generating the final output using a single 3×3×3 filter in the final convolutional layer and normalizing the output value to values between 0 and 1 through the sigmoid activation function (i.e., one of the activation functions widely used in machine learning and deep learning, a function used to convert input values to values between 0 and 1), and an operation (S104-5) of generating a high-resolution 3D image of 64*64*64 size and finally outputting the high-resolution 3D image.

FIG. 7 is a flowchart illustrating a jellyroll expansion coefficient calculation operation (S105) of FIG. 2, according to some embodiments of the present invention.

Referring to FIG. 7, the jellyroll expansion coefficient calculation operation (S105) may include an operation (S105-1) of receiving upscaled 3D data (e.g., with dimensions 64*64*64*1) of an initial scan and estimating (e.g., calculating) an initial volume by summing all voxel values, an operation (S105-2) of estimating (e.g., calculating) a current volume by summing all voxel values of the upscaled 3D data (e.g., with dimensions 64*64*64*1) of a current scan, and an operation (S105-3) of calculating the expansion coefficient as a percentage by using the equation: (current volume-initial volume)/initial volume*100.

As described above, according to the present invention, by directly observing the structural change of the jelly roll inside the battery in real time through the terahertz 3D scanning technology, it is possible to immediately detect the minute structural changes inside the battery and early detect the degradation or abnormal signs at an early stage.

In addition, according to the present invention, by generating the high-resolution 3D image using a 3D CNN that applies the Al-based super-resolution technology, it is possible to accurately capture the minute changes in the internal structure of the battery and analyze the degradation process in more detail.

In addition, according to the present invention, by detecting the chemical changes in real time using the characteristics of the terahertz waves, it is possible to monitor the chemical changes inside the battery in real time and more accurately identify the cause of the performance degradation.

In addition, according to the present invention, by analyzing the complex data patterns using advanced Al technologies such as the 3D CNN and the ensemble learning (e.g., random forest), it is possible to perform the highly accurate lifetime prediction without a large amount of long-term usage data.

In addition, according to the present invention, by performing the high-performance analysis with low power through the optimized hardware design and the efficient Al algorithm, it is possible to perform the continuous real-time monitoring and analysis even in the limited power environment of the electric vehicle (xEV).

In addition, according to the present invention, by simultaneously monitoring the state of the individual battery cells in the battery pack through the terahertz 3D scanning, it is possible to early detect and respond to the imbalances between the battery cells.

In addition, according to the present invention, by implementing the management strategy that adapts to the battery usage pattern and environment based on the real-time data and Al analysis, it is possible to perform the customized management optimized for the characteristics and usage environment of each battery and improve the overall lifetime and performance of the battery.

However, effects that can be achieved through the present invention are not limited to the above-described effects and other effects that are not described may be clearly understood by those skilled in the art from the detailed descriptions.

The embodiments described herein may be implemented, for example, as a method or process, a device, a software program, a data stream, or a signal. Although discussed in the context of a single type of implementation (for example, discussed only as a method), features discussed herein may also be implemented in other forms (for example, as a device or a program). The device may be implemented by suitable hardware, software, firmware, and the like. The method may be implemented on a device, such as a processor that generally refers to a processing device including a computer, a microprocessor, an integrated circuit, a programmable logic device, etc. The processor includes a communication device such as a computer, a cell phone, a personal digital assistant (PDA), and other devices that facilitate communication of information between the device and end-users.

Although the present disclosure has been described with reference to embodiments and drawings illustrating aspects thereof, the present disclosure is not limited thereto. Various suitable modifications and variations can be made by a person skilled in the art to which the present disclosure belongs within the scope of the present disclosure, as defined by the following claims and their equivalents.

Examples are set out in the following numbered clauses:
1. A battery condition prediction apparatus comprising:
   a processor; and
   a memory that stores instructions executed by the processor,
   wherein the processor is configured to predict a condition or a lifetime of a battery based on features extracted from scan data generated based on terahertz waves transmitted through the battery.
2. The battery condition prediction apparatus of clause 1, further comprising:
   a terahertz 3D scanning module configured to generate the terahertz waves, to receive the terahertz waves transmitted through the battery, and to convert the received terahertz waves into an electrical signal,
   wherein the processor is configured to acquire the scan data from the terahertz 3D scanning module, and
   wherein the terahertz 3D scanning module is configured to generate the terahertz waves by exciting a photoconductive antenna using a pulsed laser.
3. The battery condition prediction apparatus of clause 1 or clause 2, wherein the processor is configured to extract the features extracted from the scan data and to perform resolution upscaling through super-resolution processing to predict the condition or the lifetime of the battery.
4. The battery condition prediction apparatus of clause 3, wherein the processor is configured to calculate a jellyroll expansion coefficient based on the super-resolution processed data, and
   to predict the lifetime of the battery using at least one designated parameter comprising the jellyroll expansion coefficient using an ensemble model.
5. The battery condition prediction apparatus of any preceding clause, wherein the processor is configured to use at least one of a 3D convolutional neural network (3D CNN), a deep learning-based super-resolution technique, and an ensemble learning technique in a process of predicting the condition or the lifetime of the battery.
6. The battery condition prediction apparatus of clause 2 or any clause dependent thereon, wherein the processor is configured to:
   acquire raw 3D voxel data from the terahertz 3D scanning module,
   perform noise removal and normalization of the raw 3D voxel data through data preprocessing,
   extract spatial features of the data using a 3D CNN,
   perform 3D super-resolution processing based on the spatial features to perform data upscaling,
   calculate a jellyroll expansion coefficient using the upscaled data, and
   predict the lifetime of the battery using an ensemble model.
7. The battery condition prediction apparatus of clause 6, wherein, in order to extract the spatial features of the data, the processor is configured to:
   extract local features of input data through a first convolutional layer,
   learn a more complex combination of features extracted from the first convolutional layer through a second convolutional layer, and
   compress and refine the features through a third convolutional layer.
8. The battery condition prediction apparatus of clause 6 or clause 7, wherein, in order to perform the data upscaling by performing the 3D super-resolution processing, the processor is configured to:
   expand a spatial dimension of input data through a first deconvolutional layer,
   refine detailed features of data whose spatial dimension is expanded through a refinement convolutional layer, and reduce an artifact that occurs during the data upscaling, and
   generate a final output through a final convolutional layer and normalize an output value through a sigmoid activation function.
9. The battery condition prediction apparatus of any of clauses 6 to 8, wherein, in order to calculate the jellyroll expansion coefficient, the processor is configured to:
   estimate an initial volume by summing all voxel values of initial scan data,
   estimate a current volume by summing all voxel values of current scan data, and
   calculate the expansion coefficient as a percentage by using
   "(current volume-initial volume)/initial volume*100.
10. The battery condition prediction apparatus of any of clauses 6 to 9, wherein, in order to predict the lifetime of the battery using the ensemble model, the processor is configured to:
   generate the ensemble model comprising a plurality of decision trees trained to predict the lifetime of the battery using input variables comprising a voltage, a current, a temperature, and an expansion coefficient, and
   receive the voltage, the current, the temperature, and the expansion coefficient as inputs, and synthesize the prediction results of each decision tree by the generated ensemble model to predict the lifetime of the battery.
11. A battery condition prediction method comprising:
   extracting, by a processor, features from scan data generated based on terahertz waves transmitted through a battery; and
   predicting, by the processor, a condition or a lifetime of the battery based on the extracted features.
12. The battery condition prediction method of clause 11, wherein, in the predicting of the condition or the lifetime of the battery, the processor is configured to extract the features from the scan data and to perform resolution upscaling through super-resolution processing.
13. The battery condition prediction method of clause 12, wherein, in the predicting of the condition or the lifetime of the battery,
   the processor is configured to calculate a jellyroll expansion coefficient based on the super-resolution processed data, and
   to predict the lifetime of the battery using at least one designated parameter comprising the jellyroll expansion coefficient using an ensemble model.
14. The battery condition prediction method of any of clauses 11 to 13, wherein, in the predicting of the condition or the lifetime of the battery, the processor is configured to use at least one of a 3D convolutional neural network (3D CNN), a deep learning-based super-resolution technique, and an ensemble learning technique.
15. The battery condition prediction method of any of clauses 11 to 14, wherein, in the predicting of the condition or the lifetime of the battery, the processor is configured to:
   acquire raw 3D voxel data from a terahertz 3D scanning module,
   perform noise removal and normalization of the raw 3D voxel data through data preprocessing,
   extract spatial features of the data using a 3D CNN,
   perform 3D super-resolution processing based on the spatial features to perform data upscaling,
   calculate a jellyroll expansion coefficient using the upscaled data, and
   predict the lifetime of the battery using an ensemble model.
16. The battery condition prediction method of clause 15, wherein, in order to extract the spatial features of the data, the processor is configured to:
   extract local features of input data through a first convolutional layer,
   learn a more complex combination of features extracted from the first convolutional layer through a second convolutional layer, and
   compress and refine the features through a third convolutional layer.
17. The battery condition prediction method of clause 15 or clause 16, wherein, in order to perform the data upscaling by performing the 3D super-resolution processing, the processor is configured to:
   extract local features of input data through a first deconvolutional layer,
   refine detailed features of the data whose spatial dimension is expanded through a refinement convolutional layer and reduce an artifact that occurs during the data upscaling, and
   generate a final output through a final convolutional layer and normalizes an output value through a sigmoid activation function.
18. The battery condition prediction method of any of clauses 15 to 17, wherein, in order to calculate the jellyroll expansion coefficient, the processor is configured to:
   estimate an initial volume by summing all voxel values of an initial scan data,
   estimate a current volume by summing all voxel values of current scan data, and
   calculate the expansion coefficient as a percentage by using
   (current volume-initial volume)/initial volume*100.
19. The battery condition prediction method of any of clauses 15 to 18, wherein, in order to predict the lifetime of the battery using the ensemble model, the processor is configured to:
   generate the ensemble model comprising a plurality of decision trees trained to predict the lifetime of the battery using input variables comprising a voltage, a current, a temperature, and an expansion coefficient, and
   receive the voltage, the current, the temperature, and the expansion coefficient as inputs, and synthesize the prediction results of each decision tree by the generated ensemble model to predict the lifetime of the battery.
20. A battery pack comprising:
   a processor; and
   a memory that stores instructions executed by the processor,
   wherein the processor is configured to predict a condition or a lifetime of a battery based on features extracted from scan data generated based on terahertz waves transmitted through the battery.

## Claims

1. A battery condition prediction apparatus comprising:
a processor; and
a memory that stores instructions executed by the processor,
wherein the processor is configured to predict a condition or a lifetime of a battery based on features extracted from scan data generated based on terahertz waves transmitted through the battery.

2. The battery condition prediction apparatus of claim 1, further comprising:
a terahertz 3D scanning module configured to generate the terahertz waves, to receive the terahertz waves transmitted through the battery, and to convert the received terahertz waves into an electrical signal,
wherein the processor is configured to acquire the scan data from the terahertz 3D scanning module, and
wherein the terahertz 3D scanning module is configured to generate the terahertz waves by exciting a photoconductive antenna using a pulsed laser.

3. The battery condition prediction apparatus of claim 1 or claim 2, wherein the processor is configured to extract the features extracted from the scan data and to perform resolution upscaling through super-resolution processing to predict the condition or the lifetime of the battery.

4. The battery condition prediction apparatus of claim 3, wherein the processor is configured to calculate a jellyroll expansion coefficient based on the super-resolution processed data, and
to predict the lifetime of the battery using at least one designated parameter comprising the jellyroll expansion coefficient using an ensemble model.

5. The battery condition prediction apparatus of any preceding claim, wherein the processor is configured to use at least one of a 3D convolutional neural network (3D CNN), a deep learning-based super-resolution technique, and an ensemble learning technique in a process of predicting the condition or the lifetime of the battery.

6. The battery condition prediction apparatus of claim 2 or any claim dependent thereon, wherein the processor is configured to:
acquire raw 3D voxel data from the terahertz 3D scanning module,
perform noise removal and normalization of the raw 3D voxel data through data preprocessing,
extract spatial features of the data using a 3D CNN,
perform 3D super-resolution processing based on the spatial features to perform data upscaling,
calculate a jellyroll expansion coefficient using the upscaled data, and
predict the lifetime of the battery using an ensemble model.

7. The battery condition prediction apparatus of claim 6, wherein, in order to extract the spatial features of the data, the processor is configured to:
extract local features of input data through a first convolutional layer,
learn a more complex combination of features extracted from the first convolutional layer through a second convolutional layer, and
compress and refine the features through a third convolutional layer.

8. The battery condition prediction apparatus of claim 6 or claim 7, wherein, in order to perform the data upscaling by performing the 3D super-resolution processing, the processor is configured to:
expand a spatial dimension of input data through a first deconvolutional layer,
refine detailed features of data whose spatial dimension is expanded through a refinement convolutional layer, and reduce an artifact that occurs during the data upscaling, and
generate a final output through a final convolutional layer and normalize an output value through a sigmoid activation function.

9. A battery condition prediction method comprising:
extracting, by a processor, features from scan data generated based on terahertz waves transmitted through a battery; and
predicting, by the processor, a condition or a lifetime of the battery based on the extracted features.

10. The battery condition prediction method of claim 9, wherein, in the predicting of the condition or the lifetime of the battery, the processor is configured to extract the features from the scan data and to perform resolution upscaling through super-resolution processing.

11. The battery condition prediction method of claim 10, wherein, in the predicting of the condition or the lifetime of the battery,
the processor is configured to calculate a jellyroll expansion coefficient based on the super-resolution processed data, and
to predict the lifetime of the battery using at least one designated parameter comprising the jellyroll expansion coefficient using an ensemble model.

12. The battery condition prediction method of any of claims 9 to 11, wherein, in the predicting of the condition or the lifetime of the battery, the processor is configured to use at least one of a 3D convolutional neural network (3D CNN), a deep learning-based super-resolution technique, and an ensemble learning technique.

13. The battery condition prediction method of any of claims 9 to 12, wherein, in the predicting of the condition or the lifetime of the battery, the processor is configured to:
acquire raw 3D voxel data from a terahertz 3D scanning module,
perform noise removal and normalization of the raw 3D voxel data through data preprocessing,
extract spatial features of the data using a 3D CNN,
perform 3D super-resolution processing based on the spatial features to perform data upscaling,
calculate a jellyroll expansion coefficient using the upscaled data, and
predict the lifetime of the battery using an ensemble model.

14. The battery condition prediction method of claim 13, wherein, in order to extract the spatial features of the data, the processor is configured to:
extract local features of input data through a first convolutional layer,
learn a more complex combination of features extracted from the first convolutional layer through a second convolutional layer, and
compress and refine the features through a third convolutional layer.

15. The battery condition prediction method of claim 13 or claim 14, wherein, in order to perform the data upscaling by performing the 3D super-resolution processing, the processor is configured to:
extract local features of input data through a first deconvolutional layer,
refine detailed features of the data whose spatial dimension is expanded through a refinement convolutional layer and reduce an artifact that occurs during the data upscaling, and
generate a final output through a final convolutional layer and normalizes an output value through a sigmoid activation function.
